(19) Europäisches Patentamt / European Patent Office / Office européen des brevets

(11) EP 2 757 577 A1

(12) **EUROPEAN PATENT APPLICATION**
published in accordance with Art. 153(4) EPC

(43) Date of publication:
23.07.2014 Bulletin 2014/30

(51) Int Cl.:
$H01L\ 21/304^{(2006.01)}$ $B24B\ 37/20^{(2012.01)}$
$B24B\ 37/26^{(2012.01)}$

(21) Application number: 12831282.4

(22) Date of filing: 14.09.2012

(86) International application number:
PCT/JP2012/073633

(87) International publication number:
WO 2013/039203 (21.03.2013 Gazette 2013/12)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 16.09.2011 JP 2011202761

(71) Applicant: Toray Industries, Inc.
Tokyo, 103-8666 (JP)

(72) Inventors:
• HONDA, Tomoyuki
Otsu-shi
Shiga 520-8558 (JP)
• FUKUDA, Seiji
Otsu-shi
Shiga 520-8558 (JP)
• OKUDA, Ryoji
Otsu-shi
Shiga 520-8558 (JP)

(74) Representative: Webster, Jeremy Mark
Mewburn Ellis LLP
33 Gutter Lane
London
EC2V 8AS (GB)

(54) **POLISHING PAD**

(57) To suppress an increase in a polishing rate and deterioration of uniformity within a plane in a wafer due to shortage of the polishing rate in a central part of the wafer, a polishing pad at least includes a polishing layer, and a cushion layer, in which a plurality of holes is provided in the polishing layer, the holes passing through the polishing layer in a thickness direction, and a plurality of grooves is provided in a polishing surface of the polishing layer, a through hole ratio is from 0.13% or more to 2.1% or less, and angles made by the polishing surface and side surfaces of the groove, which continue to the polishing surface, is from 105 degrees or more to 150 degrees or less.

FIG.1

## Description

Field

The present invention relates to a polishing pad. More specifically, the present invention relates to a polishing pad preferably used for forming a planar surface in semiconductors, dielectric material/metal composites, integrated circuits, and the like.

Background

With an increase in density of semiconductor devices, the importance of a technology of forming multilayer wiring, interlayer insulating films associated therewith, and electrodes, such as a plus and a damascene electrode, has been increasing. Accordingly, the importance of a process of flattening these interlayer insulating films and metal films of the electrodes has been increasing. As an efficient technology for the flattering process, a polishing technology called chemical mechanical polishing (CMP) has been spreading.

Typically, a CMP device is made of a polishing head that holds a semiconductor wafer that is an object to be processed, a polishing pad for performing processing of polishing the object to be processed, and a polishing surface plate that holds the polishing pad. The processing of polishing the semiconductor wafer (hereinafter, simply referred to as wafer) is performed to remove a part protruding from a layer of a surface of the wafer, and to flatten the layer of the surface of the wafer, by causing the wafer and the polishing pad to perform relative movement using slurry.

Polishing properties of the CMP include various demand properties typified by local flatness of the wafer, securing of global flatness, prevention of scratching, and securing of a high polishing rate. Therefore, to achieve such demand properties, there have been various improvements about a surface structure (patterns of grooves and holes) of the polishing pad, which is one of the major factors having influence on the polishing properties.

Citation List

Patent Literature

Patent Literature 1: Japanese Patent No. 4454833
Patent Literature 2: Japanese Patent No. 3324643
Patent Literature 3: Japanese Patent No. 3042593

Summary

Technical Problem

However, when such a polishing pad including a plurality of holes and a plurality of grooves in the entire polishing surface is used, an average polishing rate in a central part of the wafer (hereinafter, sometimes simply referred to as "polishing rate") is insufficient, and therefore, there are problems of a decrease in the polishing rate and deterioration of uniformity of the polishing rate within a plane of the wafer (hereinafter, sometimes simply referred to as "uniformity within a plane") (so-called, center slow).

The present invention has been made in view of the foregoing, and an objective is to provide a polishing pad capable of suppressing a decrease in a polishing rate and deterioration of uniformity within a plane due to shortage of the polishing rate in a central part of a wafer. Solution to Problem

The inventors focused on the shape of the cross section of the grooves, and found out that the problems of the polishing pad including a plurality of holes can be solved, and remarkable effects can be obtained if the plurality of grooves is formed into "inclined grooves" described below, so that high uniformity within a plane is provided, and the "inclined grooves" are applied to the polishing pad including a plurality of holes.

That is, a polishing pad according to the present invention at least includes: a polishing layer; and a cushion layer, wherein a plurality of holes is provided in the polishing layer, the holes passing through the polishing layer in a thickness direction, and a plurality of grooves is provided in a polishing surface of the polishing layer, a through hole ratio is from 0.13% or more to 2.1% or less, and angles of both side surfaces of the groove, the angles being made by the polishing surface and the side surfaces continuing to the polishing surface, are from 105 degrees or more to 150 degrees or less. Advantageous Effects of Invention

According to the present invention, retention and flow performance of a polishing agent can be improved while a decrease in a polishing rate and deterioration of uniformity within a plane (so-called, center slow) due to shortage of the polishing rate in a central part of a wafer which is an object of the related art can be suppressed. Brief Description of Drawings

FIG. 1 is a diagram illustrating an example of shapes of cross sections of an inclined groove and a through hole of a polishing pad according to an embodiment of the present invention.
FIG. 2A is a diagram illustrating an example (first example) of the shape of the cross section of the inclined groove.
FIG. 2B is a diagram illustrating an example (second example) of the shape of the cross section of the inclined groove.
FIG. 2C is a diagram illustrating an example (third example) of the shape of the cross section of the inclined groove.
FIG. 3A is a diagram schematically illustrating an arrangement pattern (first example) of the through holes as viewed from an upper surface of a polishing layer.
FIG. 3B is a diagram schematically illustrating an arrangement pattern (second example) of the through holes as viewed from an upper surface of a polishing layer.
FIG. 4 is a partial cross-sectional view illustrating a state in which the grooves and the through holes retain slurry in the polishing pad according to the embodiment of the present invention.
FIG. 5 is a partial cross-sectional view illustrating a state in which the polishing pad according to the embodiment of the present invention retains the slurry when the polishing pad includes only the grooves of the grooves and the through holes.
FIG. 6 is a diagram schematically illustrating a groove pitch and a groove width in the polishing pad according to the embodiment of the present invention. Description of Embodiments

Hereinafter, embodiments for implementing the present invention will be described.

A surface of a polishing layer of a polishing pad in the present invention includes a groove. The groove includes side surfaces continuing to a polishing surface at edge parts in a groove width direction. Then, the groove is formed into a shape in which at least one of angles (hereinafter, sometimes referred to as "inclined angles") made by the polishing surface and the side surfaces of the groove, the side surfaces being continuing to the polishing surface, is from 105 degrees or more to 150 degrees or less, (hereinafter, the groove is sometimes referred to as "inclined groove"), whereby fluctuation in polishing rate can be suppressed while a high polishing rate can be maintained. It is considered that a suction force works between the wafer and the polishing pad, and the polishing rate is increased, by including of the shape of the groove, in which the inclined angle is from 105 degrees or more to 150 degrees or less. Further, it is considered that the uniformity within a plane of the wafer is enhanced (a polishing profile becomes flat) by the suction force accompanied with an effect that the polishing pad comes in contact with the plane of the wafer in a uniform manner.

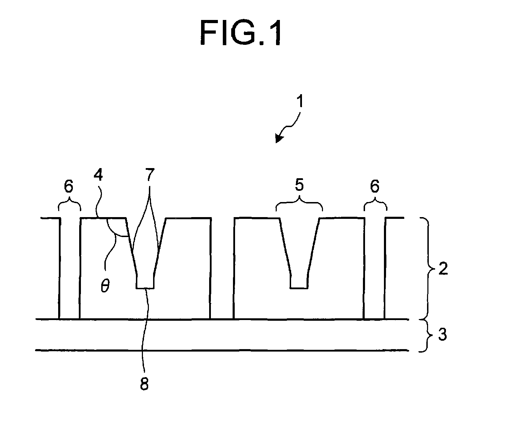

FIG. 1 is a partial cross-sectional view illustrating a configuration example of a polishing pad. A polishing pad 1 illustrated in FIG. 1 includes a polishing layer 2 and a cushion layer 3 layered with the polishing layer 2. The polishing layer 2 includes a groove 5 drilled from a polishing surface 4, and a plurality of through holes (dimples) 6 passing through the polishing layer 2 in a thickness direction. The groove 5 includes two inclined surfaces 7, each of which continues to and inclines to the polishing surface 4 by an angle θ (inclined angle), and a bottom surface 8 provided between the two inclined surfaces 7. It is preferable that the through holes 6 be processed to pass through before the cushion layer 3 is attached to the polishing layer 2. A through hole ratio is preferably from 0.13% or more to 2.1% or less. Here, the through hole ratio is a ratio of combined areas of the through holes to the total area of the polishing pad.

When the inclined angle θ is too large, the surface area of the polishing pad 1 is decreased, and the cross section area of the groove 5 becomes too large. Therefore, the slurry is excessively discharged, and the polishing rate is decreased. Meanwhile, when the inclined angle θ becomes too small, a suction effect that the inclined side surfaces of the groove have is not exerted. Therefore, it is necessary that the inclined angle θ is from 105 degrees or more to 150 degrees or less, and in terms of the retention and the flow performance of the slurry, it is more preferable if the lower limit is 120 degrees or more, or the upper limit is 140 degrees or less. Since the slurry flows by centrifugal force, it is more effective if at least a side surface positioned at the circumference side of the facing side surfaces forming the groove has the inclination.

Examples of the shape of the groove 5 as viewed from the surface side of the polishing layer 2 include a radial shape, a lattice shape, a concentric circular shape, and a spiral shape. Since the groove 5 can efficiently update the slurry if the groove has an open system extending in the circumference direction, the shape is preferably a radial shape or a lattice shape, and most preferably a lattice shape.

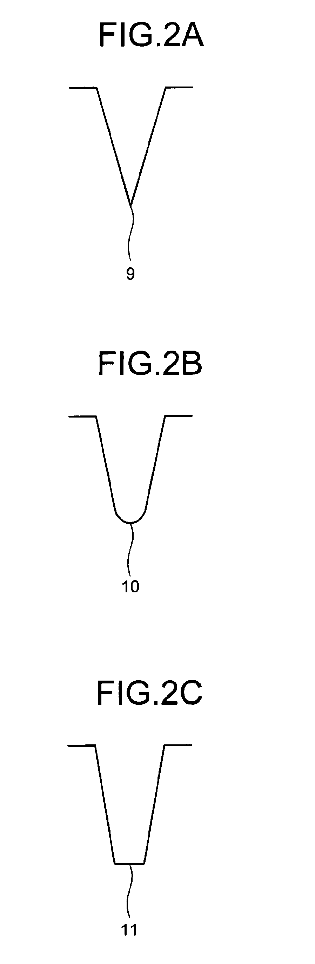

It is preferable that the groove has a bottom surface. The bottom surface 8 of the groove 5 illustrated in FIG. 1 has a rectangular cross section, and the groove 5 as a whole has a Y-shaped cross section. However, the shape of the cross section of the groove is not limited thereto. The groove may have, for example, a V-shaped cross section like a groove 9 illustrated in FIG. 2A, may have an approximately U-shaped cross section like a groove 10 illustrated in FIG. 2B, or may have a trapezoid cross section like a groove 11 illustrated in FIG. 2C.

It is preferable that the through hole 6 is provided in the entire surface of the polishing layer, and the diameter of the through hole 6 is preferably from 0.9 mm$\varphi$ or more to 2.3 mm$\varphi$ or less, and more preferably 1.2 mm$\varphi$ or more. Further, the diameter of the through hole 6 is more preferably 2.0 mm$\varphi$ or less.

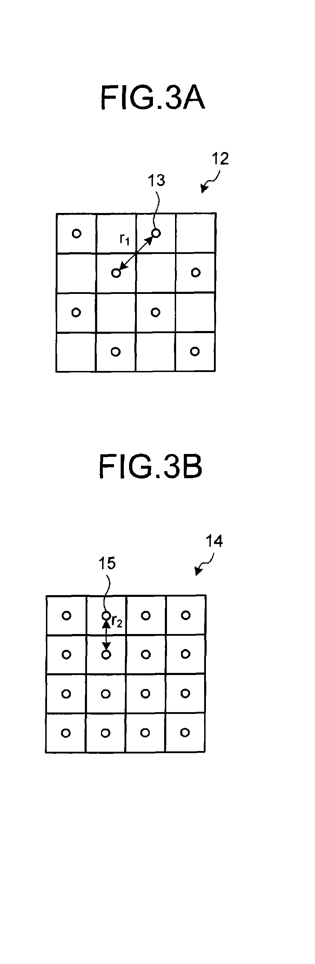

FIGS. 3A and 3B are diagrams schematically illustrating arrangement patterns of the through holes as viewed from an upper surface of the polishing layer. In a case of a polishing pad 12 illustrated in FIG. 3A, through holes 13 are arranged in a zigzag lattice manner. Further, in a case of a polishing pad 14 illustrated in FIG. 3B, through holes 15 are arranged in a square lattice manner. Here, an interval $r_1$ between the through holes 13 and an interval $r_2$ between the through holes 15 are preferably from 10.0 mm or more to 22 mm or less, and more preferably, the lower limit is 13 mm or more, or the upper limit is 18 mm or less.

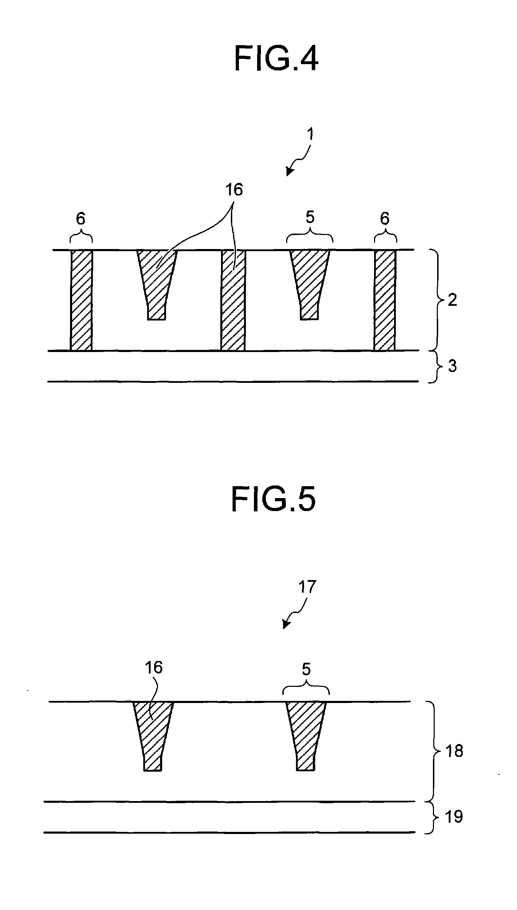

By a combination of the inclined grooves and the through holes, a polishing pad capable of suppressing a decrease in a polishing rate and the deterioration of the uniformity within a plane due to shortage of the polishing rate in a central part of a wafer, which have been the problems in the past when a polishing pad including a plurality of holes and a plurality of grooves (not the inclined grooves) is used, can be provided. FIG. 4 is a partial cross-sectional view illustrating a state in which the grooves 5 and the through holes 6 retain slurry 16 in the polishing pad 1. Further, FIG. 5 is a partial cross-sectional view illustrating a state in which when a polishing pad 17 (that includes a polishing layer 18 and a cushion layer 19) including only the grooves 5 (does not include the through holes) retains the slurry 16.

In the present invention, it is important that the polishing pad includes a cushion layer. Typically, the rigidity of the pad as a whole becomes lowered if a large number of grooves or through holes are formed in the polishing surface, resulting in deterioration of step elimination capability. Therefore, a distortion constant of the cushion layer that falls within a range from $7.3 \times 10^{-6}$ to $4.4 \times 10^{-4}$ $\mu$m/Pa, inclusive, is preferably used. The distortion constant is more preferably $3.0 \times 10^{-4}$ $\mu$m/Pa or less, and even more preferably $1.5 \times 10^{-4}$ $\mu$m/Pa or less.

Note that the distortion constant in the present invention is calculated according to the following expression:

$$\text{Distortion constant } (\mu\text{m/Pa}) = (T1 - T2)/(177 - 27)/1000$$

where the thickness is T1 ($\mu$m) when the pressure of 27 kPa is applied for 60 seconds by a dial gauge, and the thickness is T2 ($\mu$m) when the pressure of 177 kPa is then applied for 60 seconds, using an indenter having a tip, the diameter of which is 5 mm.

Example of the cushion layer include unfoamed elastomers, such as natural rubber, nitrile rubber, "neoprene (registered trademark)" rubber, polybutadiene rubber, thermosetting polyurethane rubber, thermoplastic polyurethane rubber, and silicon rubber. However, the cushion layer is not limited to these examples.

The thickness of the cushion layer is preferably within a range from 0.1 to 2 mm. In terms of the uniformity within a plane of the entire surface of the semiconductor substrate, the thickness is preferably 0.3 mm or more. Further, in terms of local flatness, the thickness is preferably 2.0 mm or less, and more preferably 1.0 mm or less.

As the polishing layer that constitutes the polishing pad, a structure including isolated bubbles is preferable because the structure forms a planar surface in a semiconductor, a dielectric material/metal composite, an integrated circuit, and the like. Further, the hardness of the polishing layer is preferably 45 to 65 degrees in an Asker D hardness meter. When the Asker D hardness is less than 45 degrees, planarity (flatting properties) of a member to be polished becomes lowered, while when the Asker D hardness is larger than 65 degrees, the planarity is favorable but the uniformity of the member to be polished tends to be lowered.

While the material to form the structure is not particularly limited, examples of the material include polyethylene, polypropylene, polyester, polyurethane, polyurea, polyamide, polyvinyl chloride, polyacetal, polycarbonate, polymethyl methacrylate, polytetrafluoroethylene, epoxy resins, ABS resins, AS resins, phenol resins, melamine resins, "neoprene (registered trademark)" rubbers, butadiene rubbers, styrene butadiene rubbers, ethylene propylene rubbers, silicon rubbers, fluorine rubbers, and resins having one of these materials as the main component. Further, two or more types of these materials may be used. Among these resins, a material having polyurethane as the main component is more preferable, because the diameter of the isolated bubbles can be relatively easily controlled.

Polyurethane means a polymer synthesized by means of polyaddition reaction or a polymerization reaction using polyisocyanate. Examples of the polyisocyanate include tolylene diisocyanate, diphenylmethane diisocyanate, naphthalene diisocyanate, hexamethylene diisocyanate, and isophorone diisocyanate. However, the polyisocyanate is not limited to the examples, and two or more types of them may be used.

A compound with which polyisocyanate reacts is a compound containing active hydrogen, that is, a compound that contains two or more polyhydroxy groups or an amino group. Polyol is typically used as a compound containing a polyhydroxy group, and examples of the polyol include polyether polyol, polytetramethylene ether glycol, epoxy resin modified polyol, polyester polyol, acryl polyol, polybutadiene polyol, and silicone polyol. As the compound containing a polyhydroxy group, two or more types of them may be used. It is preferable to determine a combination and optimum amounts of polyisocyanate, polyol, a catalyst, a foaming agent, and a foam stabilizer according to the hardness, the diameter of the bubble, and a foaming ratio.

As a method for forming the isolated bubbles in polyurethane, a chemical foaming method of mixing various types of foaming agents into a resin at the time of manufacturing polyurethane is typically used. However, a method of curing the resin after foaming the resin by means of mechanical stirring can also be preferably used.

An average diameter of the bubbles in the isolated bubbles is preferably 30 $\mu$m or more in terms of reduction in scratching. Meanwhile, in terms of flatness of local unevenness of the member to be polished, the average diameter of the bubbles in the isolated bubbles is preferably 150 $\mu$m or less, more preferably 140 $\mu$m or less, and even more preferably 130 $\mu$m or less. Note that the average diameter of the bubbles is obtained such that, with respect to circular bubbles excluding bubbles observed circular but lacked in an end part of the view, from among the bubbles observed in a single view, when a sample cross section is observed with a super focal depth profilometer microscope (VK-8500 manufactured by Keyence Corporation) at a magnification of 400 times, an equivalent circle diameter is measured from the cross section area with an image processing device, and a number-average value is calculated.

A preferable embodiment of the polishing pad in the present invention is a pad containing a polymer of a vinyl compound and polyurethane, and including the isolated bubbles. The polymer made of only a vinyl compound can increase the toughness and the hardness, but it is difficult to obtain a homogeneous polishing pad including the isolated bubbles. In addition, polyurethane becomes brittle if the hardness is increased. When the vinyl compound is impregnated with polyurethane, a tough and hard polishing pad including the isolated bubbles can be realized.

The vinyl compound is a compound having a polymerizable carbon-carbon double bond. Concretely, examples of the vinyl compound include methyl acrylate, methyl methacrylate, ethyl acrylate, ethyl methacrylate, n-butyl acrylate, n-butyl methacrylate, 2-ethylhexyl methacrylate, isodecyl methacrylate, isobutyl methacrylate, n-lauryl methacrylate, 2-hydroxyethyl methacrylate, 2-hydroxypropyl methacrylate, 2-hydroxybutyl methacrylate, dimethylaminoethyl methacrylate, diethylaminoethyl methacrylate, glycidyl methacrylate, ethylene glycol dimethacrylate, acrylic acid, methacrylic acid, fumaric acid, dimethyl fumarate, diethyl fumarate, dipropyl fumarate, maleate, dimethyl maleate, diethyl maleate, dipropyl maleate, phenylmaleimide, cyclohexylmaleimide, isopropylmaleimide, acrylonitrile, acrylamide, vinyl chloride, vinylidene chloride, styrene, $\alpha$-methyl styrene, divinylbenzene, ethylene glycol dimethacrylate, and diethylene glycol dimethacrylate. Note that two or more types of these compounds may be used as the vinyl compound.

Among the above-described vinyl compounds, $CH_2 = CR^1COOR^2$ ($R^1$: a methyl group or an ethyl group, $R^2$: a methyl group, an ethyl group, a propyl group, or a butyl group) is preferable. Among them, methyl methacrylate, ethyl methacrylate, n-butyl methacrylate, and isobutyl methacrylate are preferable, because the isolated bubbles can be easily formed in polyurethane, impregnation with monomers is favorable, curing through polymerization is easy, and a foaming structure containing a polymer of a vinyl compound cured through polymerization and polyurethane has high hardness, and the flattening properties are preferable.

Examples of the polymerization initiator preferably used for obtaining the polymer of the vinyl compound include radical initiators, such as azobisisobutylonitrile, azobis (2,4-dimethylvaleronitrile), azobiscyclohexane carbonitrile, benzoyl peroxide, lauroyl peroxide, and isopropyl peroxydicarbonate. Two or more types of them can be used. In addition, oxidation-reduction-based polymerization initiators, for example, a combination of peroxide and an amine can be used.

An example of the method of impregnating polyurethane with a vinyl compound includes a method of immersing polyurethane in a container filled with the vinyl compound. Note that, at that time, it is preferable to carry out processing such as heat application, pressure application, pressure reduction, stirring, vibration, or ultrasonic vibration in order to increase an impregnation speed.

The amount of vinyl compound with which the polyurethane is impregnated should be determined according to the type of a vinyl compound and polyurethane to be used, and the properties of the polishing pad to be manufactured. While it cannot be said sweepingly, it is preferable that the content ratio of the polymer obtained from the vinyl compound in the polymerized and cured foaming structure to the polyurethane is 30/70 to 80/20 in the weight ratio. If the content ratio of the polymer obtained from the vinyl compound is 30/70 or more in the weight ratio, the hardness of the polishing pad can be made sufficiently high. Further, if the content ratio is 80/20 or less, the elasticity of the polishing layer can be made sufficiently high.

Note that, the content by percentage of the polymer obtained from the polymerized and cured vinyl compound in the polyurethane and the polyurethane can be measured by means of a thermal decomposition gas chromatography/mass analyzing technique. As apparatuses that can be used for the technique, a double shot pyrolizer "PY-2010D" (manufactured by Frontier Laboratories Ltd.) can be used as a thermal decomposition apparatus, and "TRIO-1" (manufactured by VG Co., Ltd.) can be used as a gas chromatograph mass analyzing apparatus.

In the present invention, in terms of the flatness of local unevenness of the semiconductor substrate, it is preferable that the phase of polyurethane and the phase of the polymer obtained from the vinyl compound are contained without being separated. Quantitatively speaking, an infrared spectrum obtained through observation of the polishing pad with a microscopic infrared spectrometer having a 50 $\mu$m spot has an infrared absorption peak of polyurethane and an infrared absorption peak of a polymer polymerized from the vinyl compound and, thus, the infrared spectrums in various places are approximately the same. An example of the microscopic infrared spectrometer used here includes IRμs, manufactured by Spectra-Tech Inc.

The polishing pad may contain various types of additives, such as a polishing agent, a charge preventing agent, a lubricant, a stabilizer, and a dye, in order to improve the properties.

In the present invention, in terms of reduction in local flatness defect and a global step, the density of the polishing layer is preferably 0.3 g/cm$^3$ or more, more preferably 0.6 g/cm$^3$ or more, and even more preferably 0.65 g/cm$^3$ or more. Meanwhile, in terms of reduction in scratching, the density of the polishing layer is preferably 1.1 g/cm$^3$ or less, more preferably 0.9 g/cm$^3$ or less, and even more preferably 0.85 g/cm$^3$ or less. Note that the density of the polishing layer in the present invention has a value that was measured using water as a medium and using a Harvard type pycnometer (JIS R-3503 standard).

An example of the member to be polished in the present invention includes a surface of an insulating layer or metal wiring formed on a wafer, for example. Examples of the insulating layer include an interlayer insulating film of metal wiring, a lower layer insulating film of metal wiring, and shallow trench isolation used for element isolation. Examples of the metal wiring include aluminum, tungsten, copper, and an alloy thereof, and structurally, a damascene, a dual damascene, and a plug. In a case where the metal wiring is made of copper, a barrier metal made of silicon nitride, or the like also becomes an object to be polished. Currently most insulating films are made of silicon oxide. However, a low dielectric constant insulating film may also be used. Examples of the member to be polished include a magnetic head, a hard disk, sapphire, SiC, and a micro electro mechanical system (MEMS), other than the wafer.

The polishing method of the present invention is preferably used for forming a planar surface on glass, a semiconductor, a dielectric material/metal composite, an integrated circuit, and the like.

[Examples]

Hereinafter, details of the present invention will be described using examples. However, the present invention is not construed by the examples in a limited manner. Note that the measurement was performed as follows.

<Measurement of Diameter of Bubble>

With respect to circular bubbles excluding bubbles observed circular but lacked in an end part of the view, from among the bubbles observed in a single view, when a sample cross section is observed with a super focal depth profilometer microscope (VK-8500 manufactured by Keyence Corporation) at a magnification of 400 times, an equivalent circle diameter was measured from the cross section area with an image processing device, and a calculated number-average value was employed as the average diameter of the bubbles.

<Measurement of Hardness>

The measurement was performed in accordance with JIS K6253-1997. The fabricated polyurethane resin was cut into a size of 2 x 2 cm (the thickness is arbitrary), and the cut resin was used as a sample for measurement of hardness, and was left at rest for 16 hours under an environment of the temperature of 23 ± 2°C and the humidity of 50 ± 5%. The samples were layered to have the thickness of 6 mm or more at the measurement. The hardness was measured using a hardness meter (Asker D hardness meter manufactured by Kobunshi Keiki Co., Ltd.).

<Measurement of Inclined Angle>

A pad having a groove formed in a surface of a polishing layer was sliced in a groove depth direction by a razor blade that is arranged perpendicular to a groove direction, the cross section of the groove was observed with a super focal depth profilometer microscope of VK-8500 manufactured by Keyence Corporation, and an angle made by a polishing surface and a side surface of the groove, which continues to the polishing surface, was measured. Grooves closest to the positions of 50 mm, 250 mm, and 450 mm from the center of the polishing pad are measured, and an average of these three points was employed as the inclined angle.

<Calculation of Distortion Constant>

The distortion constant was calculated according to the following expression:

$$\text{Distortion constant } (\mu m/Pa) = (T1 - T2)/(177 - 27)/1000$$

where the thickness is T1 ($\mu$m) when the pressure of 27 kPa is applied for 60 seconds by a dial gauge, and the thickness is T2 ($\mu$m) when the pressure of 177 kPa is then applied for 60 seconds, using an indenter having a tip, the diameter of which is 5 mm.

<Calculation of Average Polishing Rate>

Polishing was performed under a predetermined polishing condition using a Mirra 3400 manufactured by Applied Materials, Inc. 37 points on the plane within the radius of 90 mm or less from the center were measured every 5 mm and 18 points on the plane within the radius of 91 mm or more from the center were measured every 1 mm, and the average polishing rate (nm/min) was calculated.

<Calculation of Uniformity within Plane>

Polishing was performed under a predetermined polishing condition using a Mirra 3400 manufactured by Applied Materials, Inc. The polishing properties were measured in the diameter direction excluding 1 mm of the outermost periphery of the 8-inch wafer. 37 points on the plane within the radius of 90 mm or less from the center were measured every 5 mm and 18 points on the plane within the radius of 91 mm or more from the center were measured every 1 mm, and the uniformity within a plane (%) was calculated according to the following expression:

$$\text{Uniformity within a plane} = (\text{the maximum value of the polishing rate} - \text{the minimum value of the polishing rate})/\text{the average polishing rate}$$

(Example 1)

30 parts by weight of polypropylene glycol, 40 parts by weight of diphenylmethane diisocyanate, 0.5 part by weight of water, 0.3 part by weight of triethylamine, 1.7 parts by weight of a silicone foaming agent, and 0.09 part by weight of tin octylate were mixed in an RIM molding machine, and the mixture was discharged into a mold for pressure molding and, a foam polyurethane sheet with isolated bubbles was fabricated.

The above-described foam polyurethane sheet was immersed for 60 minutes in methyl methacrylate to which 0.2 part by weight of azobisisobutylonitrile was added. Next, the above-described foam polyurethane sheet was immersed in a solution of 15 parts by weight of polyvinyl alcohol "CP" (manufactured by Nacalai Tesque, Inc., the degree of polymerization: approximately 500), 35 parts by weight of ethyl alcohol (special class reagent manufactured by Katayama Chemical Industries Co., Ltd.), and 50 parts by weight of water, and was then dried, so that the surface layer of the foam polyurethane sheet was coated with polyvinyl alcohol.

Next, the foam polyurethane sheet was sandwiched between two glass plates through a gasket made of vinyl chloride, and is heated for 6 hours at 65°C and for three hours at 120°C, so that the sheet was cured through polymerization. The sheet was removed from the glass plates, washed with water, and dried in a vacuum at 50°C. The hard foam sheet thus obtained was sliced to have the thickness of 2.00 mm, so that a polishing layer was fabricated. The methyl methacrylate content by percentage in the polishing layer was 66 weight%. Further, the D hardness of the polishing layer was 54 degrees, the density was 0.81 g/cm$^3$, and the average diameter of the bubbles in the isolated bubbles was 45 $\mu$m.

Both surfaces of the obtained hard foam sheet were ground, and a polishing layer having the thickness of 2 mm was fabricated.

The entire polishing layer obtained by the above-described method was processed to have through holes, such that holes having 1.7 mm$\varphi$ continue in a square lattice manner, and the interval between the through holes is 14.14 mm. The through hole ratio was 1.1%.

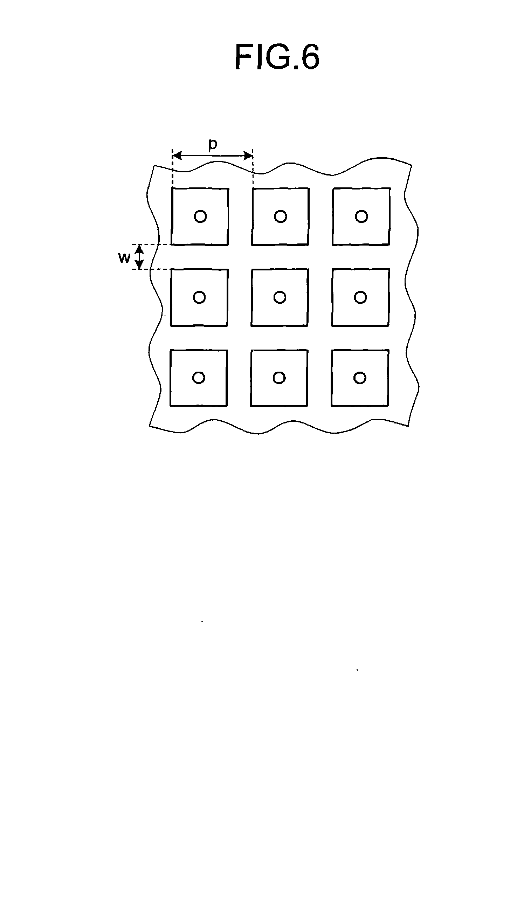

Next, thermoplastic polyurethane (the thickness of the cushion layer: 0.3 $\mu$m) having the distortion constant of 0.15 $\times$ 10$^{-4}$ $\mu$m/Pa manufactured by Nihon Matai Co., Ltd., was layered through an MA-6203 adhesive layer manufactured by Mitsui Chemicals Polyurethanes, Inc., using a roll coater, which serves as the cushion layer, and further, a double-sided tape 5604TDM, manufactured by Sekisui Chemical Co., Ltd., was pasted on the rear surface as a rear surface tape. A groove having a groove pitch of 15 mm, the inclined angle of 135 degrees, the V-shaped cross section, the groove width of 1.5 mm, and the groove depth of 1.5 mm is formed in the surface of the polishing layer throughout the pad in an XY lattice manner, such that the groove passes between the previously provided through holes (= a through hole is arranged in the center of an XY lattice groove tile). The layered body was punched into a circle having the diameter of 508 mm, and was used as the polishing pad. FIG. 6 is a diagram schematically illustrating a groove pitch p and a groove width w in the polishing pad. Note that the circle mark in FIG. 6 represents a through hole.

The polishing pad obtained by the above-described method was attached to the surface plate of a polishing machine ("Mirra 3400" manufactured by Applied Materials, Inc.). One-hundred 8-inch wafers with an oxide film were polished under a retainer ring pressure of 55 kPa (6 psi), an inner tube pressure of 28 kPa (4 psi), a membrane pressure of 28 kPa (4 psi), the number of rotations of platen of 76 rpm, the number of rotations of the polishing head of 75 rpm, with slurry (SS-25 = 1:1 (volume rate) manufactured by Cabot Corporation) flowing at a flowing rate of 150 mL/min, with an application of a load of 17.6 N (4 lbf), for a polishing time of 1 min, using in situ dressing. The average polishing rate of the 100th wafer was 217 nm/min, and the uniformity within a plane was 25.0%.

(Comparative Example 1)

Polishing was performed similarly to Example 1 except that an inclined angle $\theta$ of a polishing pad was 90 degrees (a rectangular groove was employed instead of an inclined groove). The average polishing rate of the 100th wafer was 201 nm/min, and the uniformity within a plane was 39.7%. As a result, the average polishing rate of the 100th wafer was lower, and the uniformity within a plane was poorer (= the value was larger) than those of Example 1.

(Comparative Example 2)

Polishing was performed similarly to Example 1 except that an inclined angle $\theta$ of a polishing pad was 160 degrees. The average polishing rate of the 100th wafer was 198 nm/min, and the uniformity within a plane was 36.1%. As a result, the average polishing rate of the 100th wafer was lower, and the uniformity within a place was poorer (= the value was larger) than those of Example 1.

(Comparative Example 3)

While groove processing was same as Example 1, and the diameter of a through hole was 1.75 mm$\varphi$, which was also the same as Example 1, a polishing pad having the interval between the through holes of 4.8 mm, which is narrower than Example 1, was used. The through hole ratio of the polishing pad was 9.9%, which was higher than 1.1% of Example 1. As a result of polishing using the above polishing pad under the same polishing environment and conditions as Example 1, the average polishing rate of the 100th wafer was 183 nm/min, and the uniformity within a plane was 31.8%. The average polishing rate of the 100th wafer was lower, and the uniformity within a plane was poorer (= the value was larger) than those of Example 1.

(Comparative Example 4)

Groove processing was the same as Comparative Example 3. A polishing pad having the interval between through holes of 7.01 mm, and the through hole ratio being lower than Comparative Example 3 was used. The through hole ratio of the polishing pad was 4.5%. As a result of polishing using the above polishing pad under the same polishing environment and conditions as Example 1, the average polishing rate was 190 nm/min, the uniformity within a plane was 29.2%, and polishing properties were improved, compared with Comparative Example 3. However, the polishing rate was lower, and the uniformity within a plane was poorer (= the value was larger) than those of Example 1.

Results obtained through the above-described Example 1, and Comparative Examples 1 to 4 are shown in Table 1.

Table 1

|  | Example 1 | Comparative Example 1 | Comparative Example 2 | Comparative Example 3 | Comparative Example 4 |
|---|---|---|---|---|---|
| Shape of cross-section of groove | V | Rectangle | V | V | V |
| Inclined angle $\theta$ (degree) | 135 | 90 | 160 | 135 | 135 |

(continued)

| | Example 1 | Comparative Example 1 | Comparative Example 2 | Comparative Example 3 | Comparative Example 4 |
|---|---|---|---|---|---|
| Interval between through holes (mm) | 14.14 | 14.14 | 14.14 | 4.8 | 7.01 |
| Through hole ratio (%) | 1.1 | 1.1 | 1.1 | 9.9 | 4.5 |
| Average polishing rate of 100th wafer (nm/min) | 217 | 201 | 198 | 183 | 190 |
| Uniformity within surface (%) | 25.0 | 39.7 | 36.1 | 31.8 | 29.2 |

Reference Signs List

| | |
|---|---|
| 1, 12, 14, and 17 | Polishing pad |
| 2 and 18 | Polishing layer |
| 3, and 19 | Cushion layer |
| 4 | Polishing surface |
| 5, 9, 10, and 11 | Groove |
| 6, 13, and 15 | Through hole (dimple) |
| 7 | Inclined surface |
| 8 | Bottom surface |
| 16 | Slurry |
| p | Groove pitch |
| w | Groove width |

**Claims**

1. A polishing pad at least comprising:

   a polishing layer; and
   a cushion layer,
   wherein a plurality of holes is provided in the polishing layer, the holes passing through the polishing layer in a thickness direction, and a plurality of grooves is provided in a polishing surface of the polishing layer,
   a through hole ratio is from 0.13% or more to 2.1% or less, and
   angles of both side surfaces of the groove, the angles being made by the polishing surface and the side surfaces continuing to the polishing surface, are from 105 degrees or more to 150 degrees or less.

2. The polishing pad according to claim 1, wherein the grooves in a surface of the polishing layer have a lattice shape.

# FIG.1

## FIG.2A

9

## FIG.2B

10

## FIG.2C

11

# FIG.3A

# FIG.3B

# FIG.4

# FIG.5

# FIG.6

**INTERNATIONAL SEARCH REPORT**

| International application No. |
| --- |
| PCT/JP2012/073633 |

A. CLASSIFICATION OF SUBJECT MATTER
*H01L21/304*(2006.01)i, *B24B37/20*(2012.01)i, *B24B37/26*(2012.01)i

According to International Patent Classification (IPC) or to both national classification and IPC

B. FIELDS SEARCHED

Minimum documentation searched (classification system followed by classification symbols)
H01L21/304, B24B37/20, B24B37/26

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| A | JP 2003-511848 A (Koninklijke Philips Electronics N.V.), 25 March 2003 (25.03.2003), paragraphs [0016] to [0017]; fig. 1A to 1B & US 6346032 B1 & EP 1305139 A & WO 2001/024969 A2 & DE 60044469 D & CN 1337898 A | 1-2 |
| A | JP 2010-528885 A (Applied Materials Inc.), 26 August 2010 (26.08.2010), paragraphs [0016], [0024]; fig. 3 & US 2008/0305729 A1 & WO 2008/154185 A2 & TW 200906543 A | 1-2 |

☒ Further documents are listed in the continuation of Box C.　　☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>15 October, 2012 (15.10.12) | Date of mailing of the international search report<br>30 October, 2012 (30.10.12) |
| --- | --- |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2012/073633

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2006-165323 A  (Seiko Epson Corp.), 22 June 2006 (22.06.2006), paragraphs [0055] to [0057]; fig. 9 to 10 (Family: none) | 1-2 |
| A | JP 2000-286218 A  (Nikon Corp.), 13 October 2000 (13.10.2000), paragraph [0025]; fig. 5 & US 6749714 B1          & EP 1211023 A1 & WO 2000/059680 A1      & DE 60039054 D & TW 511174 B            & TW 530348 B & CN 1551303 A           & CN 1345264 A | 1-2 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4454833 B
- JP 3324643 B

- JP 3042593 B